# EUROPEAN PATENT SPECIFICATION

(11) **EP 2 619 790 B1**
(45) Date of publication and mention of the grant of the patent: **28.03.2018**
(21) Application number: 11827704.5
(22) Date of filing: 24.09.2011
(51) Int. Cl.: C25F 3/12, C25F 7/00

(54) **HIGH-THROUGHPUT BATCH POROUS SILICON MANUFACTURING EQUIPMENT DESIGN AND PROCESSING METHODS**
ENTWURF EINER AUSRÜSTUNG ZUR HERSTELLUNG VON PORÖSEM SILICIUM MIT HOHEM DURCHSATZ UND VERARBEITUNGSVERFAHREN DAFÜR
CONCEPTION D'UN ÉQUIPEMENT DE FABRICATION DE SILICIUM POREUX PAR LOTS À HAUTE CAPACITÉ ET PROCÉDÉS DE TRAITEMENT

(30) Priority: 24.09.2010 US 386318 P
(43) Date of publication of application: 31.07.2013
(73) Proprietor: Solexel, Inc., Milpitas, CA 95035-7405 (US)
(72) Inventor: YONEHARA, Takao, Milpitas CA 95035 (US); TAMILMANI, Subramanian, Fremont, CA 94536 (US); KRAMER, Karl-josef, San Jose CA 95125 (US); ASHJAEE, Jay, Cupertino CA 95014 (US); MOSLEHI, Mehrdad, M., Los Altos CA 94024 (US); MIYAJI, Yasuhiro, Kyoto, 602-8585 (JP); HAYASHI, Tokuyuki, Minami-ku Kyoto (JP); INAHARA, Takamitsu, Minami-ku Kyoto (JP)
(74) Representative: WP Thompson
(86) International application number: PCT/US2011/053183
(87) International publication number: WO 2012/040688

(56) References cited:
- EP-A1- 0 597 428
- WO-A1-2010/083422
- US-A- 5 976 311
- US-A1- 2003 008 473
- US-B1- 6 197 654
- US-B1- 6 235 147
- US-B1- 6 726 815

## Description

### FIELD

The overall application fields of this disclosure cover many areas including but not limited to solar photovoltaics, semiconductor microelectronics, micro-electro-mechanical systems (MEMS), and optoelectronics. In the field of photovoltaics, this disclosure enables high-productivity fabrication of semiconductor-based sacrificial separation layers (made of porous semiconductors such as porous silicon), buried optical reflectors (made of multi-layer / multi-porosity porous semiconductors such as porous silicon), formation of porous semiconductor (such as porous silicon) for anti-reflection coatings, passivation layers, and multijunction, multi-band gap solar cells (for instance, by forming a wider band gap porous silicon emitter on crystalline silicon thin film or wafer based solar cells). In the semiconductor field, it enables fabrication of sacrificial MEMS separation layers for die detachment, and shallow trench isolation (STI) porous silicon (using porous silicon formation with an optimal porosity and its subsequent oxidation). Other applications include the general fields of MEMS, including sensors and actuators, stand-alone, or integrated with integrated semiconductor microelectronics. Another range of applications pertains to high-surface area reaction test-vehicles for food and drug evaluation.

### BACKGROUND

Crystalline silicon (including multi- and monocrystalline silicon) is the most dominant absorber material for commercial solar photovoltaic (PV) applications, currently accounting for well over 80% of the solar PV market. There are different known methods of forming monocrystalline silicon film and releasing or transferring the grown semiconductor (e.g., monocrystalline silicon) layer. Regardless of the methods, a low cost epitaxial silicon deposition process accompanied by a high-volume, production-worthy low cost method of release layer formation are prerequisites for wider use of silicon solar cells.

Porous silicon (PS) formation is a fairly new field with an expanding application landscape. Porous silicon is created by the electrochemical etching of silicon wafers with appropriate doping in an electrolyte bath. The electrolyte for porous silicon is: HF (49% in H₂O typically), isopropyl alcohol (IPA) (and/or acetic acid), and deionized water (DI H₂O). IPA (and/or acetic acid) serves as a surfactant and assists in the uniform creation of PS. Additional additives such as certain salts may be used to enhance the electrical conductivity of the electrolyte, thus reducing its heating and power consumption through ohmic losses.

Porous silicon has been used as a sacrificial layer in MEMS and related applications, where there is a much higher tolerance for cost per unit area of the wafer and resulting product than solar PV. Typically porous silicon is produced on simpler and smaller single-wafer electrochemical process chambers with relatively low throughputs on smaller wafer footprints. Currently there is no commercially available porous silicon equipment that allows for a high throughput, cost effective porous silicon manufacturing. The viability of this technology in solar PV applications hinges on the ability to industrialize the process to large scale (at much lower cost), requiring development of very low cost-of-ownership, high-productivity porous silicon manufacturing equipment.

### SUMMARY

The present disclosure includes several embodiments for the batch processing of semiconductor (silicon in some embodiments) wafers to produce layers of porous semiconductor. Options for processing wafers of different shapes are presented, as well as different geometries advantageous for removing reaction gases, minimizing current leakage, and allowing for efficient wafer handling.

### BRIEF DESCRIPTION OF THE DRAWINGS

The features, nature, and advantages of the disclosed subject matter will become more apparent from the detailed description set forth below when taken in conjunction with the drawings, in which like reference numerals indicate like features and wherein:
**FIG. 1** shows a prior-art single-wafer porous silicon electrolytic bath arrangement;
**FIG. 2** shows an n-batch stack series array porous silicon electrolytic bath arrangement;
**FIG. 3A** shows a chamber design for square wafers;
**FIG. 3B** shows a tilted chamber design for square wafers;
**FIG. 4** shows a chamber design for round wafers;
**FIG. 5** shows two designs for wafer clamps;
**FIG. 6** shows a chamber design with fluid fill and vent ports;
**FIG. 7A** shows a bath-in-bath chamber design; and
**FIG. 7B** shows another embodiment of a bath-in-bath chamber design.

### DETAILED DESCRIPTION

Although the present disclosure is described with reference to specific embodiments, one skilled in the art could apply the principles discussed herein to other areas and/or embodiments without undue experimentation.

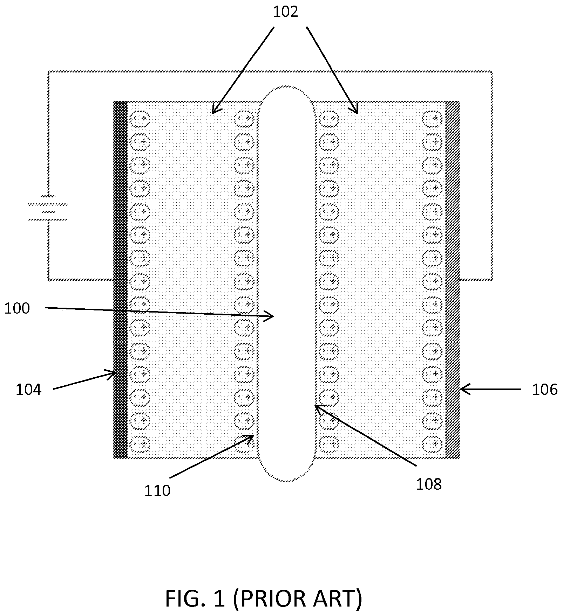

One novel aspect in the porous silicon system designs and processing methods of this disclosure lies in the batch parallel or multi-wafer processing architecture (batch stack architecture), similar to low-cost large batch wet chemical processing in benches or tanks. Presently available porous silicon tools rely on single wafer processing which characteristically burdens each wafer with high capital cost, serial cumulative processing times, relatively high electrical power consumption per wafer, and excessive wafer handling/sealing resulting in potential yield losses. The novel designs of this disclosure may reduce the capital cost by a factor approximately equal to or even greater than the number of wafers in each batch stack or array. Furthermore, the proposed design simplifies and reduces the capital cost of automation, reduces the tool footprint and enables downstream rinsing and drying. **FIG. 1** shows a very basic diagram of a single wafer porous silicon electrolytic bath arrangement (prior art). Wafer **100** is placed in electrolyte bath **102,** between anode **104** and cathode **106.** In one embodiment, electrolyte bath **102** may be HF/IPA. A porous silicon film is created on wafer frontside **108** as current is passed through the system; no porous silicon is formed on wafer backside **110.** As current runs through the system, hydrogen gas may be evolved at cathode **106** and wafer backside **110;** oxygen gas may be evolved at anode **104** and wafer frontside **108.**

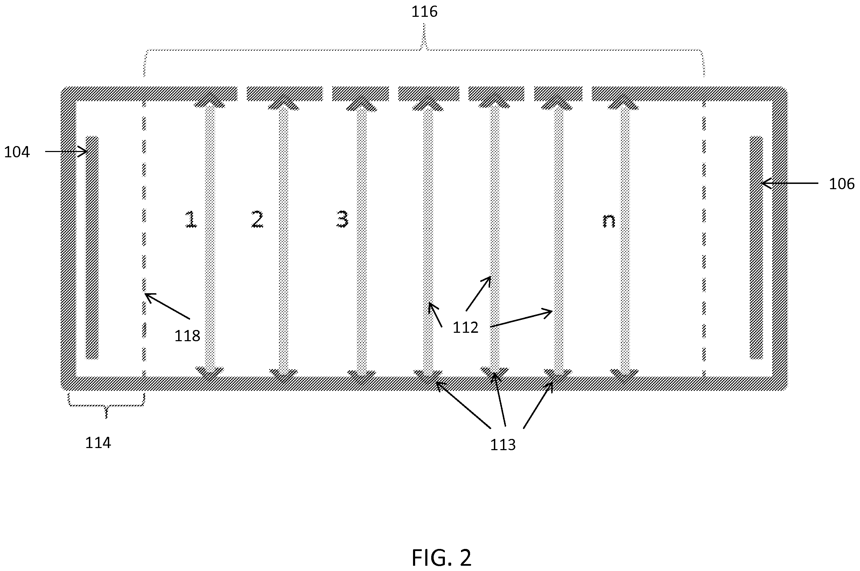

**FIG. 2** reveals the basic form of the "n" batch stack series array (which is an embodiment of this disclosure). In this arrangement wafers **112** are stacked substantially parallel with respect to one another and may be oriented vertically (or alternatively horizontally or in other orientations) with the electrode assembly on either end of the batch reactor or bath. Wafers **112** are held in place by wafer clamps **113.** The number of wafers can be increased from 1 to n (with n being a minimum of 2 and a maximum at least in the tens of wafers) and large number of wafers can be stacked just by increasing the length of the reactor. The maximum value of "n" is based on the acceptable size of the batch reactor for the optimal tool foot print, chemical utilization, required electric power for "n" wafers, etc. Processing multiple wafers plays nicely into cost-of-ownership (CoO) reduction. The key advantages of this batch design are the ability to share the chemical electrolyte bath, use a single pair of electrodes and reduce overall materials/components required in this multi-wafer scheme.

The details about the individual components of the batch reactor are explained below.

### ELECTRODE ASSEMBLY/ELECTRODE CHAMBER

The embodiment includes multiple architecture of the electrode assembly. The simple version is a solid electrode plate or a film etc. The inert electrode, such as diamond, graphite, platinum, or any other suitable material, does not corrode or etch during the electrochemical reaction. The second embodiment of the electrode assembly is a compartmentalized electrode chamber as shown in **FIG. 2****.** In this case, electrode chambers **114** are separated from reaction chamber **116,** which holds the actual process electrolyte and the wafers. The electrode chamber is separated from the process chamber by the means of conducting membrane **118** (allows electric field to pass through but prevents the transfer of chemical ions and molecules). The membrane can be self-standing or be sandwiched by some perforated non conducting plates to provide mechanical stability. This separation or compartmentalization allows for the use of different electrolyte chemicals (various compositions, chemical components, etc.) in the electrode chambers and the process chambers without interfering with each other.

### PROCESS CHAMBER

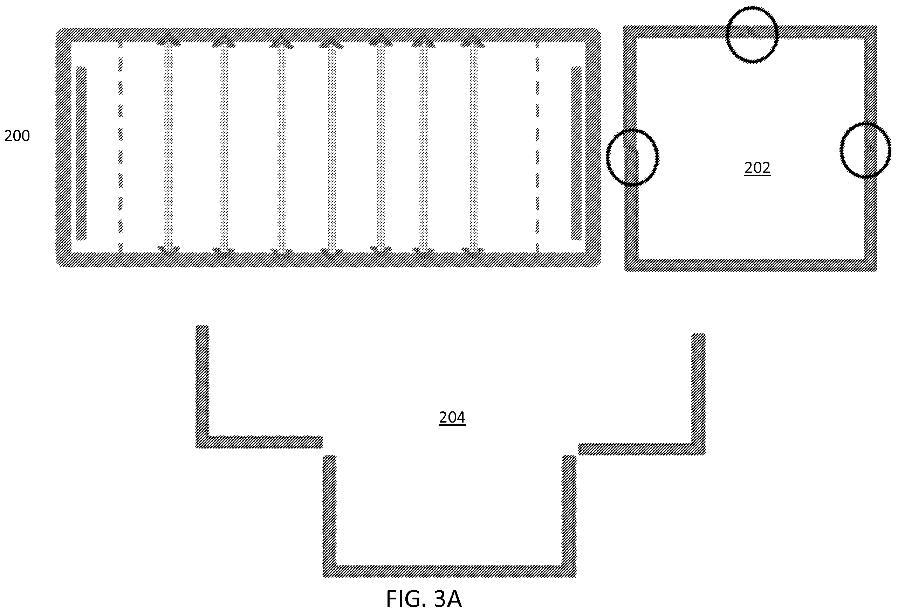

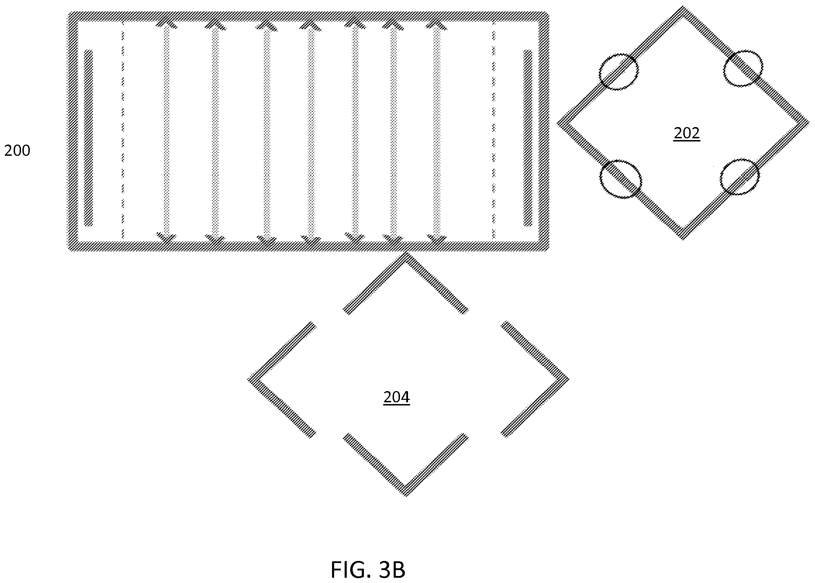

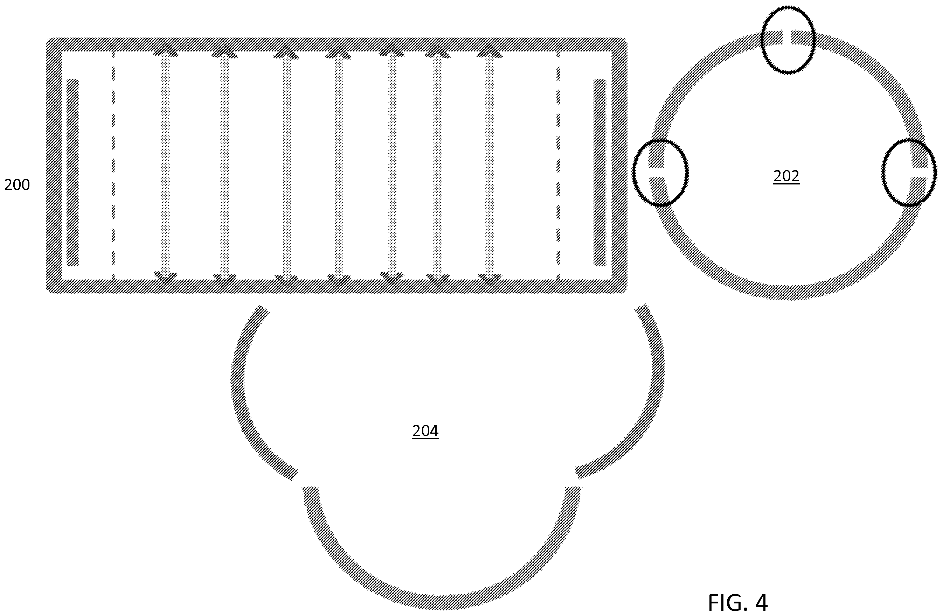

The process chamber holds the wafers and the electrolyte. The embodiment covers a wide range of process chamber dimensions to be able to create porous silicon on wafers of various geometries such as, but not limited to round, square, pseudo square(square with truncated corners) with rounder corners of varying degrees, as well as rectangular structures. Schematics of a 200 mm round and 165 mm square process chambers are shown in **FIGS. 3A****,** **3B****,** and **4****.** Each of those figures shows side view **200,** closed sectional view **202,** and open sectional view **204.**

The substrates involved may be essentially flat with varying degree of roughness or may be structured to form 3-dimensional patterns or structured with films that locally inhibit or enable porous silicon formation.

The process chambers are envisioned to be able to open in multiple sections, like a clam shell as shown in **FIGS. 3A****,** **3B****,** and **4****.** This allows easy loading of a batch of wafers (n wafers at a time) when the upper portions of the chamber walls are open. Once the wafers are secured in the lower portion of the chamber, the sides and top portion of the chamber close/ latch around the wafers. This creates a hermetic seal between the chamber wall and each individual wafer. This is extremely critical as the electric field from the electrodes on either end of the process chamber is required to pass through the wafers to form relatively uniform and repeatable porous silicon layers. The chamber of the square wafer can be installed with a wide variety of tilt from 0 degree (as shown in **FIG. 3A**) to 45 degree (as shown in **FIG. 3B**). The wide range of tilt or wafer orientation allows for the choice of optimal chemical flow and gas escape during the anodization process.

### WAFER HOLDERS AND SEAL

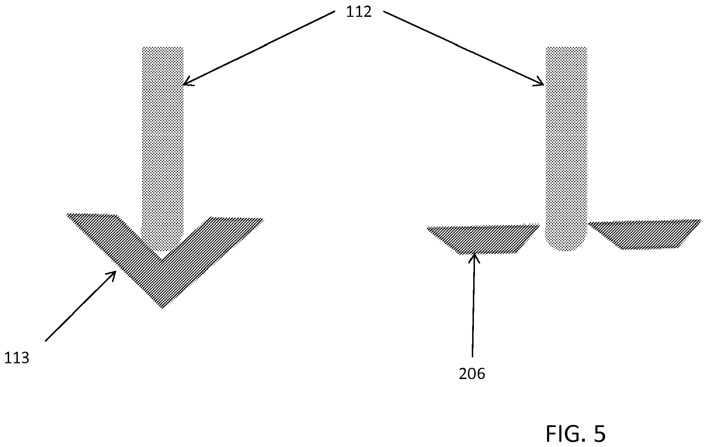

A key requirement of the porous silicon process is to get substantially uniform porous silicon coverage on the full surface of the wafer, in some embodiments without any edge exclusions. This requires that no areas of wafer edge should be blocked or covered by any material that will prevent uniform electric field distribution and direct contact with the chemistry. One embodiment covers designs of mechanical features that can hold the wafer in place, but with zero to negligible contact points and blocking points on the wafer. As shown in **FIG. 2**, a simple clamp type wafer holder may be used to enable this capability. An enlarged image of the wafer holder is shown in **FIG. 5****.** Wafer clamp **206** lacks this desirable property, preventing the formation of PS around the edge of the wafer.

Another critical item is the choice of sealing material around the inner walls of the process chamber. The chamber walls will be lined with either a single layer of chemically inert (HF and organic resistant) insulating rubber or foam to provide a leak-free seal between the wafer edge and the chamber wall or the wafer holders. This is critical to prevent any chemical leak or electric field leakage in areas where the clam shell chamber walls lock.

### ELECTRIC FIELD OPTIMIZATION

The batch chamber design with the compartmentalized electrode chamber allows for electric modulation as well. The parameters such as electrode dimension, gap between electrode and closest wafer, gap from wafer to wafer, etc. can easily be modified to achieve the required uniformity for the electric field. Another key component is the spacers used to hold the membrane discussed above. The shape and patterns on the insulating spacer can also be modified to achieve the best electric field uniformity on the wafer. In circumstances where a varying electric field (thereby varying thickness or porosity of porous silicon) is required for the integrated process flow, the spacer design can be used to control the required electric field without changing the chamber design.

### FLUID FLOW AND HYDROGEN VENT

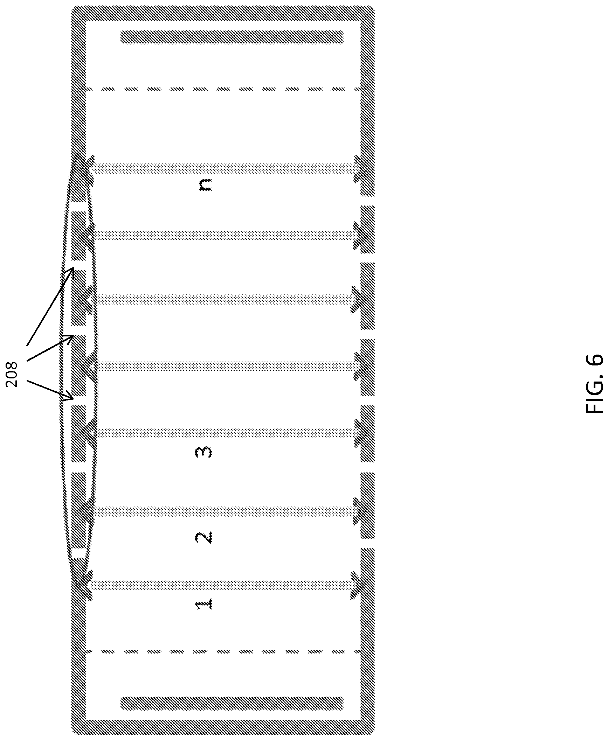

The chamber may be designed with fluid fill and vent ports **208** on the top of the chamber as shown in **FIG. 6****.** As shown, this embodiment also includes designs of fluid inlet and outlet ports at other locations of the chamber to achieve the best electrolyte replenishment to the wafer (to minimize the impact of reaction byproducts) and maintain a consistent chemical concentration.

One challenge with any porous silicon chamber is handling the hydrogen (H₂) gas generated as a result of the anodic etch reaction. Hydrogen evolves from the surface of the wafer and each electrode. Since the bath is integral with electrical current transmission, H₂ gas blocks current flow and supply of chemicals to the reaction surface, thus affecting porous silicon formation and continuity/uniformity. It is therefore critical to effectively and rapidly purge or sweep H₂ byproducts from the surfaces of the wafer and electrodes. The wafer gap, fluid flow and design of the flow ports determine the effectiveness of the sweep. While sweeping H₂ is fairly simple in terms of fluid mechanics, some consideration is warranted to mitigate the current loss from the fluid ports. Since the fluid lines are connected from wafer to wafer, depending on the geometry of the ports, line size and length, current can leak or bypass each wafer. Therefore, isolation of each port is advantageous. Also, for example, reducing the line diameter and increasing the length results in greater electrical resistance which reduces current losses or bypass losses. The current field lines are also influenced by the geometry adjacent to the wafer. So, large flow ports are less desirable compared to multiple small ports.

### BATH IN BATH DESIGN

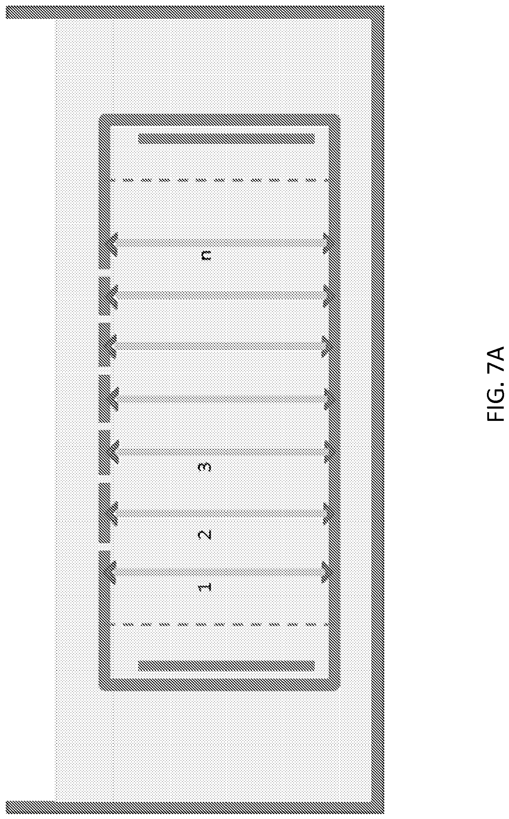

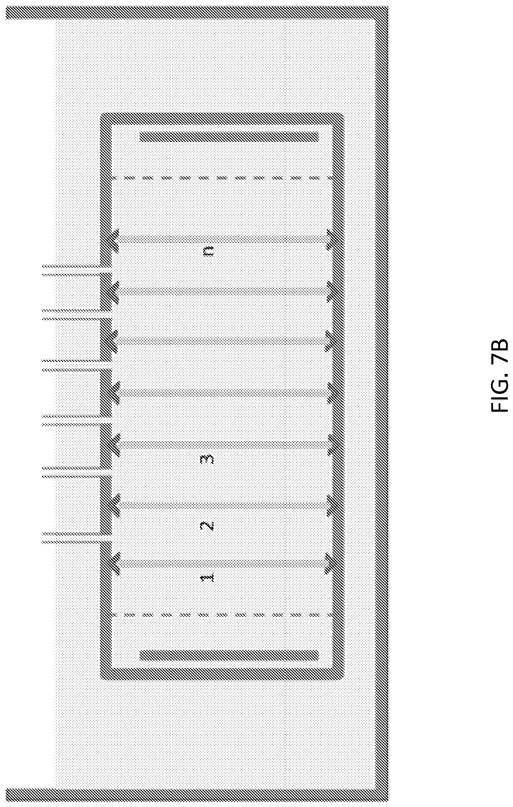

Typical wet chemical baths and process chambers use direct fluid fill/drain of the process chamber, wherein the chemical is directly pumped in the process chamber. This may require additional fill and drain times before the process can start and results in loss of productivity. This embodiment also covers a new design termed as "bath in bath" for the PS production as shown in **FIGS. 7A** and **7B****.**

There are at least two embodiments of this bath in bath design:
a) Prefilled inner chamber that is immersed and lifted out completely into and from the bath
b) Resident bath-in-bath with wafers being handled using auto loader that handles a batch of wafers and that places the batch into the lower holder part of the inside bath, then retreats.

In design a) the process chamber is pre-loaded with wafers and filled with the process chemicals. The entire assembly is then immersed into a larger bath which is pre-filled with the process chemical/electrolyte. The ports/vents on the top of the chamber allow for the electrolyte to fill the process chamber if and when the liquid level drops in the process chamber due to the reaction or other means of loss such as evaporation. Once the process is complete, the process chamber unlocks and is pulled out and the standby process chamber is immediately immersed in the larger bath minimizing loss in productivity due to wafer load/unload and chamber fill and drain. The larger bath is designed with its own pumping and recirculation system to maintain the required concentration and temperature. This methodology allows having multiple process chambers that can be introduced into the main bath without any loss in productivity.

In design b), the chamber is an integral part of the tool or the larger bath and always remains immersed in the main bath, but the chamber can open and close. It is envisioned that loading mechanisms such as robotic handlers can transfer a batch of n wafers into the base of the process chamber. After the wafer handlers have moved away from the process chamber, the outer walls of the process chamber close. This action not only secures the wafers, but also encloses the process chemicals in to the process chamber. The additional vents and ports allow the process chamber to be filled completely to the required level and maintain the same level throughout the process.

In any case, the top of the vent ports may be outside of the liquid, such that an electrically connecting path outside of the inner bath is avoided. This embodiment is shown in **FIG. 7B****.**

The embodiments of design a) and design b) can be combined into a hybrid utilizing the loading mechanism from design a) and the sealing mechanism from design b). In this hybrid design, the bottom section of the chamber remains in the outer bath. The wafers are pre-loaded into the top (and side) portion of the chamber, which acts both as a handling mechanism and a partial chamber. The preloaded wafers are then immersed in the outer bath until the wafers make contact with the lower portion of the chamber. The chamber walls are then closed tight with an actuator mechanism ensuring a leak-proof chamber.

The batch porous silicon equipment design embodiments described above can be used to form either single-layer or multi-layer porous silicon on one or both sides of the wafers in the batch. Porous silicon can be formed on only one side of the wafers by applying the electrical current flowing in only one direction without a change in the current polarity. On the other hand, porous silicon can be formed on both sides of the wafers by alternating the current flow direction at least once or multiple times. The electrical current density (in conjunction with the HF concentration) controls the layer porosity. Thus, the layer porosity can be increased by increasing the electrical current density and conversely can be reduced by reducing the electrical current density. Multi-layer porous silicon can be formed by modulating or changing the electrical current level in time during the porous silicon formation process. For instance, starting the porous silicon process with a lower current density followed by a higher current density results in formation of a lower porosity layer on top of a higher porosity buried layer. A graded porosity porous silicon layer can be formed by, for instance, linearly modulating or varying the electrical current density in time. One can use this approach to form any porous silicon structure with 1 to many porous silicon layers with 1 to many porosity values.

Those with ordinary skill in the art will recognize that the disclosed embodiments have relevance to a wide variety of areas in addition to those specific examples described above.

The foregoing description of the exemplary embodiments is provided to enable any person skilled in the art to make or use the claimed subject matter. Various modifications to these embodiments will be readily apparent to those skilled in the art, and the generic principles defined herein may be applied to other embodiments without the use of the innovative faculty. Thus, the claimed subject matter is not intended to be limited to the embodiments shown herein but is to be accorded the widest scope consistent with the scope of the claims.

## Claims

1. A bath-in-bath batch processing apparatus for producing porous semiconductor on a plurality of semiconductor wafers, comprising:
an electrolyte-filled outer housing;
an electrolyte-filled inner housing removable from said outer housing, said inner housing operable to open and close, and forming a seal when closed;
an anode disposed at a first end of said inner housing;
a cathode disposed at an opposite end of said inner housing, said anode and said cathode coupled to electrical circuitry capable of providing an electrical power comprising electrical voltage and current;
a plurality of semiconductor wafers arranged between said anode and said cathode, wherein each said wafer is held in place by a perimeter wafer clamp disposed around a perimeter of said wafer, said perimeter wafer clamp allowing substantially all of a front and a back surface of each said wafer exposure to said electrolyte;
a plurality of vent ports in said inner housing for allowing evolved hydrogen gas to escape, said vent ports extending beyond a surface of said electrolyte to prevent current leakage through said vent ports; and
a plurality of fluid fill ports in said inner housing for replenishing said electrolyte and sweeping said hydrogen gas away from said plurality of wafers.

2. A bath-in-bath apparatus for producing porous semiconductor on a plurality of semiconductor wafers, comprising:
an electrolyte-filled outer housing;
an electrolyte-filled inner housing affixed within said outer housing, said inner housing operable to open and close, and forming a seal when closed;
an anode disposed at a first end of said inner housing;
a cathode disposed at an opposite end of said inner housing, said anode and said cathode coupled to electrical circuitry capable of providing an electrical power comprising electrical voltage and current;
a plurality of semiconductor wafers arranged between said anode and said cathode, wherein each said wafer is held in place by a perimeter wafer clamp disposed around a perimeter of said wafer, said perimeter wafer clamp allowing substantially all of a front and a back surface of each said wafer exposure to said electrolyte;
a loading and unloading mechanism for transferring batches of said semiconductor wafers into and out of said inner housing;
a plurality of vent ports in said inner housing for allowing evolved hydrogen gas to escape, said vent ports extending beyond a surface of said electrolyte to prevent current leakage through said vent ports; and
a plurality of fluid fill ports in said inner housing for replenishing said electrolyte and sweeping said hydrogen gas away from said plurality of wafers.

3. The apparatus of Claim 1 or 2, further comprising a conductive anode membrane separating said anode from said plurality of semiconductor wafers.

4. The apparatus of any one of the preceding claims, further comprising a conductive cathode membrane separating said cathode from said plurality of semiconductor wafers.

5. The apparatus of any one of the preceding claims, wherein said electrical circuitry is operable to produce a graded porosity layer of porous semiconductor comprising at least two different porosities on said plurality of semiconductor wafers.

6. The apparatus of Claim 5, wherein said graded porosity layer comprises a higher porosity in depth compared to a lower porosity on the surface.

7. The apparatus of any one of the preceding claims, wherein said electrical circuitry is operable to produce a multilayer of porous semiconductor on said plurality of semiconductor wafers, said multilayer comprising discrete layers of porous semiconductor having at least two different porosities.

8. The apparatus of Claim 7,wherein said multilayer comprises a buried porous semiconductor layer with a higher porosity value and a surface porous semiconductor layer with a lower porosity value.

9. The apparatus of Claim 5,wherein said electrical circuitry is operable to produce a porous semiconductor layer on both sides of each of said plurality of semiconductor wafers by switching a voltage polarity and current direction during the porous semiconductor formation process.

10. The apparatus of Claim 5, wherein said semiconductor wafers are crystalline silicon wafers and said porous semiconductor is porous silicon.

## Patentansprüche

1. Bad-in-Bad-Stapelprozess-Vorrichtung zum Herstellen von porösem Halbleiter auf einer Mehrzahl von Halbleiter-Wafern, umfassend:
ein elektrolytgefülltes äußeres Gehäuse;
ein elektrolytgefülltes inneres Gehäuse, das aus dem äußeren Gehäuse entnehmbar ist, wobei das innere Gehäuse auf und zu gemacht werden kann und eine Dichtung bildet, wenn es geschlossen ist;
eine Anode, die an einem ersten Ende von dem inneren Gehäuse angeordnet ist;
eine Kathode, die an einem gegenüberliegenden Ende von dem inneren Gehäuse angeordnet ist, wobei die Anode und die Kathode mit einer elektrischen Schaltung gekoppelt sind, die in der Lage ist, elektrische Leistung einschließlich von elektrischer Spannung und elektrischem Strom liefern zu können;
eine Mehrzahl von Halbleiter-Wafern, die zwischen der Anode und der Kathode angeordnet sind, wobei jeder der Wafer durch eine Wafer-Umfangsklemme gehalten ist, die um den Umfang des Wafers herum angeordnet ist, wobei die Wafer-Umfangsklemme es gestattet, dass im Wesentlichen die gesamte Vorder- und Rückseite von jedem Wafer dem Elektrolyt ausgesetzt ist;
eine Mehrzahl von Entlüftungsabzügen in dem inneren Gehäuse, um entstehendes Wasserstoffgas entweichen zu lassen, wobei sich die Entlüftungsabzüge über eine Oberfläche von dem Elektrolyt hinaus erstrecken, um Leckstrom durch die Entlüftungsabzüge zu verhindern; und
eine Mehrzahl von Fluideinfüllöffnungen in dem inneren Gehäuse, um das Elektrolyt aufzufüllen und das Wasserstoffgas von der Mehrzahl von Wafern wegzuschwemmen.

2. Bad-in-Bad-Stapelprozess-Vorrichtung zum Herstellen von porösem Halbleiter auf einer Mehrzahl von Halbleiter-Wafern, umfassend:
ein elektrolytgefülltes äußeres Gehäuse;
ein elektrolytgefülltes inneres Gehäuse, das in dem äußeren Gehäuse befestigt ist, wobei das innere Gehäuse auf und zu gemacht werden kann und eine Dichtung bildet, wenn es geschlossen ist;
eine Anode, die an einem ersten Ende von dem inneren Gehäuse angeordnet ist;
eine Kathode, die an einem gegenüberliegenden Ende von dem inneren Gehäuse angeordnet ist, wobei die Anode und die Kathode mit einer elektrischen Schaltung gekoppelt sind, die in der Lage ist, elektrische Leistung einschließlich von elektrischer Spannung und elektrischem Strom liefern zu können;
eine Mehrzahl von Halbleiter-Wafern, die zwischen der Anode und der Kathode angeordnet sind, wobei jeder der Wafer durch eine Wafer-Umfangsklemme gehalten ist, die um den Umfang des Wafers herum angeordnet ist, wobei die Wafer-Umfangsklemme es gestattet, dass im Wesentlichen die gesamte Vorder- und Rückseite von jedem Wafer dem Elektrolyt ausgesetzt ist;
ein Be- und Entlademechanismus, um Stapel von den Halbleiter-Wafern in das Innengehäuse hinein und aus dem Innengehäuse heraus zu transferieren;
eine Mehrzahl von Entlüftungsabzügen in dem inneren Gehäuse, um entstehendes Wasserstoffgas entweichen zu lassen, wobei sich die Entlüftungsabzüge über eine Oberfläche von dem Elektrolyt hinaus erstrecken, um Leckstrom durch die Entlüftungsabzüge zu verhindern; und
eine Mehrzahl von Fluideinfüllöffnungen in dem inneren Gehäuse, um das Elektrolyt aufzufüllen und das Wasserstoffgas von der Mehrzahl von Wafern wegzuschwemmen.

3. Vorrichtung nach Anspruch 1 oder 2, weiterhin eine leitende Anodenmembran umfassend, welche die Anode von der Mehrzahl von Halbleiter-Wafern trennt.

4. Vorrichtung nach einem der vorstehenden Ansprüche, weiterhin eine leitende Kathodenmembran umfassend, welche die Kathode von der Mehrzahl von Halbleiter-Wafern trennt.

5. Vorrichtung nach einem der vorstehenden Ansprüche, wobei die elektrische Schaltung betreibbar ist, um eine Schicht mit abgestufter Porosität aus porösem Halbleiter herzustellen, die wenigstens zwei unterschiedliche Porositäten auf der Mehrzahl von Halbleiter-Wafern umfasst.

6. Vorrichtung nach Anspruch 5, wobei die Schicht mit abgestufter Porosität in der Tiefe eine größere Porosität aufweist im Vergleich zu einer geringeren Porosität an der Oberfläche.

7. Vorrichtung nach einem der vorstehenden Ansprüche, wobei die elektrische Schaltung betreibbar ist, um eine Mehrfachschicht aus porösem Halbleiter auf der Mehrzahl von Halbleiter-Wafern herzustellen, wobei die Mehrfachschicht diskrete Schichten von porösem Halbleiter umfasst, die wenigstens zwei unterschiedliche Porositäten haben.

8. Vorrichtung nach Anspruch 7, wobei die Mehrfachschicht eine vergrabene poröse Halbleiterschicht mit einem höheren Porositätswert aufweist und eine oberflächliche poröse Halbleiterschicht mit einem niedrigeren Porositätswert.

9. Vorrichtung nach Anspruch 5, wobei die elektrische Schaltung betreibbar ist, um eine poröse Halbleiterschicht auf beiden Seiten von jedem der Mehrzahl von Halbleiter-Wafern herzustellen, indem eine Spannungspolarität und Stromrichtung während des Bildungsprozesses des porösen Halbleiters gewechselt wird.

10. Vorrichtung nach Anspruch 5, wobei die Halbleiter-Wafer kristalline Silizium-Wafer sind und der poröse Halbleiter poröses Silizium ist.

## Revendications

1. Dispositif pour un traitement par lot bain dans bain pour réaliser un semi-conducteur poreux sur une pluralité de tranches de semi-conducteur, comprenant :
un boîtier externe rempli d'électrolyte ;
un boîtier interne rempli d'électrolyte, lequel peut être retiré du boîtier externe, le boîtier interne pouvant être ouvert et fermé et formant un élément d'étanchéité lorsqu'il est fermé ;
une anode agencée à une première extrémité du boîtier interne ;
une cathode agencée à une extrémité opposée du boîtier interne, l'anode et la cathode étant couplées par un circuit électrique capable de fournir une puissance électrique incluant une tension électrique et un courant électrique ;
une pluralité de tranches de semi-conducteur agencées entre l'anode et la cathode, chaque tranche étant maintenue par un élément de serrage périphérique de tranche agencé autour du périmètre de la tranche, l'élément de serrage périphérique de tranche permettant d'exposer sensiblement l'ensemble de la face avant et de la face arrière de chaque tranche à l'électrolyte ;
une pluralité de cheminées de ventilation dans le boîtier interne pour permettre à l'hydrogène gazeux qui se forme de s'échapper, les cheminées de ventilation s'étendant au-delà d'une surface de l'électrolyte pour empêcher un courant de fuite par les cheminées de ventilation et
une pluralité d'orifices de remplissage de fluide dans le boîtier interne pour remplir l'électrolyte et évacuer l'hydrogène gazeux de la pluralité de tranches.

2. Dispositif pour un traitement par lot bain dans bain pour réaliser un semi-conducteur poreux sur une pluralité de tranches de semi-conducteur, comprenant :
un boîtier externe rempli d'électrolyte ;
un boîtier interne rempli d'électrolyte, lequel est fixé au boîtier externe, le boîtier interne pouvant être ouvert et fermé et formant un élément d'étanchéité lorsqu'il est fermé ;
une anode agencée à une première extrémité du boîtier interne ;
une cathode agencée à une extrémité opposée du boîtier interne, l'anode et la cathode étant couplées par un circuit électrique capable de fournir une puissance électrique incluant une tension électrique et un courant électrique ;
une pluralité de tranches de semi-conducteur agencées entre l'anode et la cathode, chaque tranche étant maintenue par un élément de serrage périphérique de tranche agencé autour du périmètre de la tranche, l'élément de serrage périphérique de tranche permettant d'exposer sensiblement l'ensemble de la face avant et de la face arrière de chaque tranche à l'électrolyte ;
un mécanisme de chargement et de déchargement pour transférer des lots de tranches de semi-conducteur dans le boîtier interne et hors du boîtier interne ;
une pluralité de cheminées de ventilation dans le boîtier interne pour permettre à l'hydrogène gazeux qui se forme de s'échapper, les cheminées de ventilation s'étendant au-delà d'une surface de l'électrolyte pour empêcher un courant de fuite par les cheminées de ventilation et
une pluralité d'orifices de remplissage de fluide dans le boîtier interne pour remplir l'électrolyte et évacuer l'hydrogène gazeux de la pluralité de tranches.

3. Dispositif selon la revendication 1 ou 2, comprenant en outre une membrane anodique conductrice qui sépare l'anode de la pluralité de tranches de semi-conducteur.

4. Dispositif selon l'une des revendications précédentes, comprenant en outre une membrane cathodique conductrice qui sépare la cathode de la pluralité de tranches de semi-conducteur.

5. Dispositif selon l'une des revendications précédentes, le circuit électrique pouvant être exploité pour réaliser une couche à porosité échelonnée qui comprend au moins deux porosités différentes sur la pluralité de tranches de semi-conducteur.

6. Dispositif selon la revendication 5, la couche à porosité échelonnée présentant en profondeur une porosité plus importante en comparaison avec une porosité moindre à la surface.

7. Dispositif selon l'une des revendications précédentes, le circuit électrique pouvant être exploité pour réaliser une multicouche de semi-conducteur poreux sur la pluralité de tranches de semi-conducteur, la multicouche comprenant des couches discrètes de semi-conducteur poreux présentant au moins deux porosités différentes.

8. Dispositif selon la revendication 7, la multicouche présentant une couche de semi-conducteur poreux inférieure avec une valeur de porosité supérieure et une couche de semi-conducteur poreux de surface avec une valeur de porosité inférieure.

9. Dispositif selon la revendication 5, le circuit électrique pouvant être exploité pour réaliser une couche de semi-conducteur poreux sur les deux côtés de chacune des tranches de la pluralité de tranches de semi-conducteur par alternance de la polarité de la tension et du sens du courant pendant le processus de formation de semi-conducteur poreux.

10. Dispositif selon la revendication 5, les tranches de semi-conducteur étant des tranches de silicium cristallin et le semi-conducteur poreux étant du silicium poreux.
